# EUROPEAN PATENT SPECIFICATION

(11) **EP 1 505 608 B1**
(45) Date of publication and mention of the grant of the patent: **18.10.2006**
(21) Application number: 03425539.8
(22) Date of filing: 06.08.2003
(51) Int. Cl.: G11C 29/00

(54) **Memory system with error detection device**
Speichersystem mit Fehlererkennungsvorrichtung
Système de mémoire avec un dispositif de détection d'erreur

(43) Date of publication of application: 09.02.2005
(73) Proprietor: STMicroelectronics S.r.l., 20041 Agrate Brianza (Milano) (IT)
(72) Inventor: Battaia, Alberto, 21027 Ispra (Varese) (IT)
(74) Representative: Long, Giorgio

(56) References cited:
- DE-A- 3 530 257
- US-A- 5 216 672
- US-B1- 6 430 709
- PATENT ABSTRACTS OF JAPAN vol. 017, no. 040 (P-1475), 26 January 1993 (1993-01-26) & JP 04 256000 A (NEC ENG LTD), 10 September 1992 (1992-09-10)
- PATENT ABSTRACTS OF JAPAN vol. 008, no. 237 (P-310), 30 October 1984 (1984-10-30) & JP 59 112494 A (FUJI DENKI SEIZO KK), 28 June 1984 (1984-06-28)

## Description

The present invention relates to semiconductor memories and in particular relates to a memory system comprising an error detection device.

Non-volatile memories, such as for example, EPROM, EEPROM and FLASH memories, are used in many applications, such as, for example, "automotive" applications, i.e. those relating to motor vehicles.

In particular, the electronic devices that make up the most innovative motor vehicle function control and monitoring systems include non-volatile memories in which the data or instructions allowing for the motor vehicle to be controlled are contained.

The data relating to some of the abovementioned functions, especially those connected to the operation of motor vehicle's safety systems such as, for example, ABS and airbags, must remain unvaried throughout the system's entire life.

In actual fact, this objective is difficult to achieve in that non-volatile memories are used, often for long periods of time (for example, more than 10 years), in environments in which different types of electronic noise, radiations or other sources of disturbance cause the deterioration of the content.

Moreover, it must not be forgotten that current integration technologies are increasingly aimed at incrementing the performance of semiconductor memories (e.g. by reducing cell dimensions and increasing access speed) thus leading to an increase in their sensitivity to the effects of noise. Document US-A-5 216 672 discloses a memory system an indicated in the preamble of claim 1. It describes a memory testing system for an electronic computing system including multiple memory modules. Each module is equipped with error detecting and correcting circuitry and it is operable in a diagnostic test mode wherein read and write tests of the modules are performed in parallel.

According to a conventional methodology, the problem of memory content deterioration is solved by the identification of the errors in the data contained in the memories themselves and their subsequent, optional, correction.

In particular, according to the entity of the error, in certain types of application it may be sufficient, where possible, to intervene on the memory correcting it, whereas in other cases it is advisable to signal the presence of the error in any case.

For example, if an error occurs in the memory locations that contain data for control of the airbag function of a motor vehicle it is convenient to inform the user of the problem by means of a signal (for example the switching on of a luminous pilot light on the dashboard) rather than merely correcting the error automatically. In actual fact, given that the occurrence of errors indicates that memory performance is deteriorating, when these errors involve the motor vehicle's safety systems, it is convenient to proceed with a more thorough and systematic overhauling of the memory itself.

Currently, error identification in non-volatile memories is achieved by two different check modes.

According to a first check mode, a microprocessor (central processing unit or CPU), that controls the motor vehicle's various functions (the CPU that cooperate within a motor vehicle may be more than one), reveals the presence of errors in concomitance with the reading operations of the normal data and the performance of the instructions contained in memory locations. In particular, the CPU notices errors in the memory read using an error detection and/or correction code, such as, for example, the code for the control of the parity bit or error correction codes.

A second check mode provides that, after suitable time intervals, the CPU interrupts normal applications to dedicate itself to controlling the content of the memory. In this case, the CPU considers the data stored in the memory not as instructions to be carried out, but as information to be checked with the aid of one of the error detection and/or correction codes mentioned previously.

The drawback of the first check mode is that the CPU notices the errors present in the instructions contained in the memory only after having performed them or when they are performed. In this way, it is not possible to allow the CPU to handle the occurrence of an error in a preventative way and sometimes prevent the CPU from performing the erroneous instructions that may alter the correct operation of the system.

Moreover, in the specific case of a CPU pertaining to a gearcase for the control of a motor vehicle's engine, it is not possible to hypothesise the suspension of the function of the CPU after the performance of an erroneous instruction. In actual fact, in this case, one would leave the engine dangerously running without external supervision. This constitutes a restriction of the first check mode.

The drawback of the second check mode consists in the excessive load of operations for the CPU assigned the task of checking memory content. In order to tackle this excessive burden of operations, so that the control system's performance does not deteriorate greatly, the CPU must be made with a particularly fast microprocessor: this inevitably entails additional costs.

Moreover, upon system start up, i.e. in correspondence with the phase commonly known as system RESET, the microprocessor reads a first portion of the memory (or all of it if it is not too large) performing the instructions it contains without this portion having been controlled previously. For example, the first portion of the memory may contain instructions useful in guiding the microprocessor in the memory content control phase. The abovementioned unchecked first memory portion might contain errors such as to produce actions that are completely different from those expected. This constitutes a limitation to the second check mode.

The object of the present invention is to propose an improved memory system with relation to the systems that implement the first and second check mode.

The object is achieved by a memory system as described in the attached claim 1. Preferred embodiments of the invention's memory system are defined in the dependent claims 2 to 11.
The object of the present invention is also a memory system control method in agreement with claim 12. Preferred embodiments of this method are defined by the dependent claims 13 to 17.

The characteristics and advantages of the present invention will be made clear by the following detailed description of an example and non-limiting embodiment in relation to the following drawings, wherein:
- figure 1 is a schematic depiction of a memory system in accordance with the present invention;
- figure 2 schematically shows one of the possible implementations of a control logic structure in accordance with the present invention.

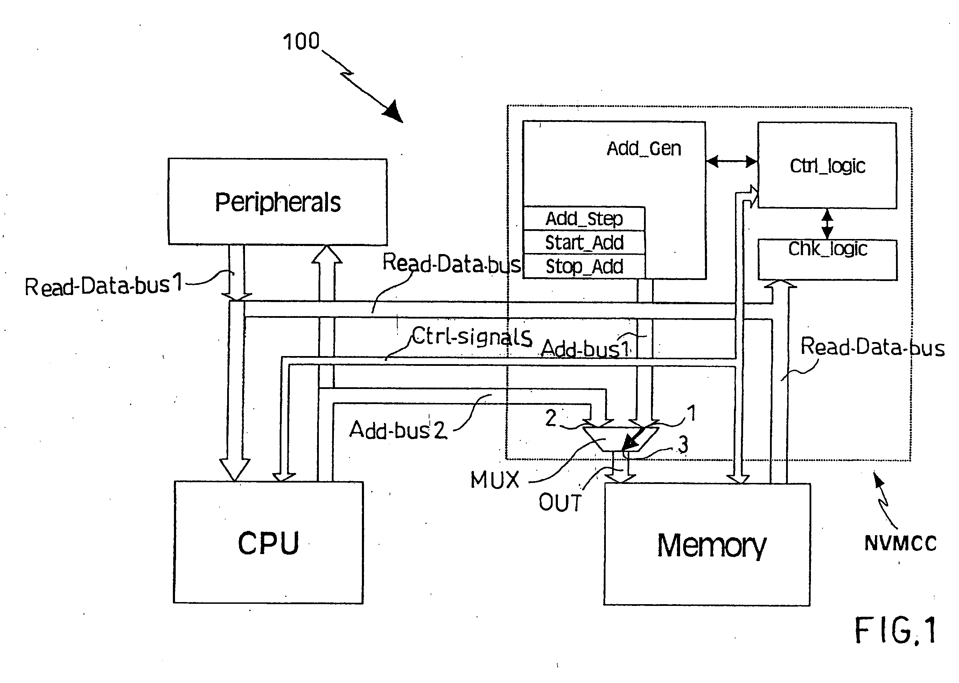

Figure 1 shows a block diagram of a memory system 100 in accordance with the present invention. The memory system 100 can be achieved by integration on a chip of semiconductor material according to techniques known to those skilled in the art.

According to the particular example described, the memory system 100 comprises a memory matrix for storing digital data that is schematised by a block Memory. This memory matrix or simply memory Memory is, for example, of a non-volatile type and can comprise EPROM, EEPROM or FLASH-type cells.

Moreover, the system 100 is provided with processing and controlling means CPU such as to interact with the memory Memory in order to read the digital data in it or the instructions to perform on such data. The processing means CPU can be made by a conventional processing system including, for example, one or more microprocessors, a digital signal processor DSP or a circuit for direct access to the memory DMA having the function of conveying onto other peripheral devices the content of the memory.

For clarity purposes, in the rest of the description these processing means CPU will be indicated for short with the term microprocessor.

The memory system 100 comprises a not-volatile memory content checker NVMCC having an error detection role in the memory Memory.

Advantageously, the checker device NVMCC is structurally distinct from the microprocessor CPU and constitutes a logic device dedicated to the checking of the content of the memory Memory in order to detect the presence of alterations in the digital data stored in it.

In greater detail, the checker device NVMCC, schematised in figure 1, includes three main functional blocks that interact with one another.

A first block is a control logic Ctrl_logic that is implemented, preferably, by a digital state machine. This state machine, about which we will speak in greater detail below, is able to manage access to the locations of the memory Memory and to check the exactness of the data they contain.

A second block is an address generator Add_Gen that comprises, typically, a counter (not shown in figure 1). The address generator Add_Gen is such to count the memory locations that the device NVMCC accesses starting from a start address Start_Add as far as a final address Stop_Add, by subsequently incrementing the start address Start_Add by a step value Add_Step. The start address Start_Add, the stop address Stop_Add and the step value Add_Step are contained inside special registers making up the address generator Add_Gen and indicated in figure 1 with the same references Start_Add, Stop_Add and Add_Step.

The content of these registers can be modified during the operation of the memory system 100. In particular, the step value Add_Step is modified according to whether the memory to be read is, for example, a 8-, 32- or 64- bit memory.

A third block is a check logic Chk_logic that comprises therein, for example, also a signature register (not shown in figure 1). This check logic Chk_logic has the function of evaluating the correctness of the content of the memory Memory by one of the error detection and/or correction codes, for example, the CRC code.

The checker device NVMCC also comprises a multiplexing circuit or multiplexer MUX having, schematically, two inputs and one output. In fact, the multiplexer MUX is connected by a first input 1 to a first line or first digital address bus Add_bus1 and by a second input 2 to a second line or second digital address bus Add_bus2.

The first address bus Add_bus1 is connected to the address generator Add_Gen, whilst the second address bus Add_bus2 is connected to the microprocessor CPU. One output 3 of the multiplexer MUX is connected to the memory Memory with a further line or address bus OUT. The multiplexer MUX is such to select the addresses to be sent to the memory Memory from those present on the first bus Add_bus1 or on the second bus Add_bus2 and is commanded by the control logic Ctrl_logic.

The system 100 is also provided with a digital data reading line, or, for short, a data bus Read_Data_bus for sending signals corresponding to the data read in the memory Memory to the microprocessor CPU and to the check logic Chk_logic.

The microprocessor CPU is connected to further peripheral devices or memories, schematised by a functional block Peripherals, in order to receive from them a second group of digital data.

In particular, this second data group can flow to the microprocessor CPU by means of a further data reading bus Read_Data_bus1.

Finally, as highlighted in figure 1, the microprocessor CPU is connected to the memory Memory and to the control logic Ctrl_logic by a line for digital control signals or, briefly, a control signals bus Ctrl_signals.

For example, some control signals are enabling signals for the memory Memory, in other words, signals by means of which the microprocessor CPU or the control logic Ctrl_logic inform the same memory Memory that the reading of given locations will start.

Similarly, other signals enable/disable the outputs memory Memory, i.e the memory Memory informs the microprocessor CPU or the control logic Ctrl_logic whether it is available for reading or not.

It will be clear to those skilled in the art that the memory system 100 comprises a timing circuit (not shown in figure 1) for suitably synchronising the succession of different operations performed within the system. In actual fact, as is known, the timing circuit provides sequences of timing pulses, commonly defined as clock pulses, which govern the temporal duration of accesses to the memory Memory by the microprocessor CPU, the checker device NVMCC or other peripheral devices. In this way, it is possible to manage the duration of memory location reading operations, the performance of the instructions they contain and the check of the data stored in the memory.

For clarity purposes, in the following of the description reference will be made to intervals of time or access time slots to indicate, in a general way, the temporal duration of accesses to the memory Memory. In particular, each time slot can be constituted by one or more clock pulses.

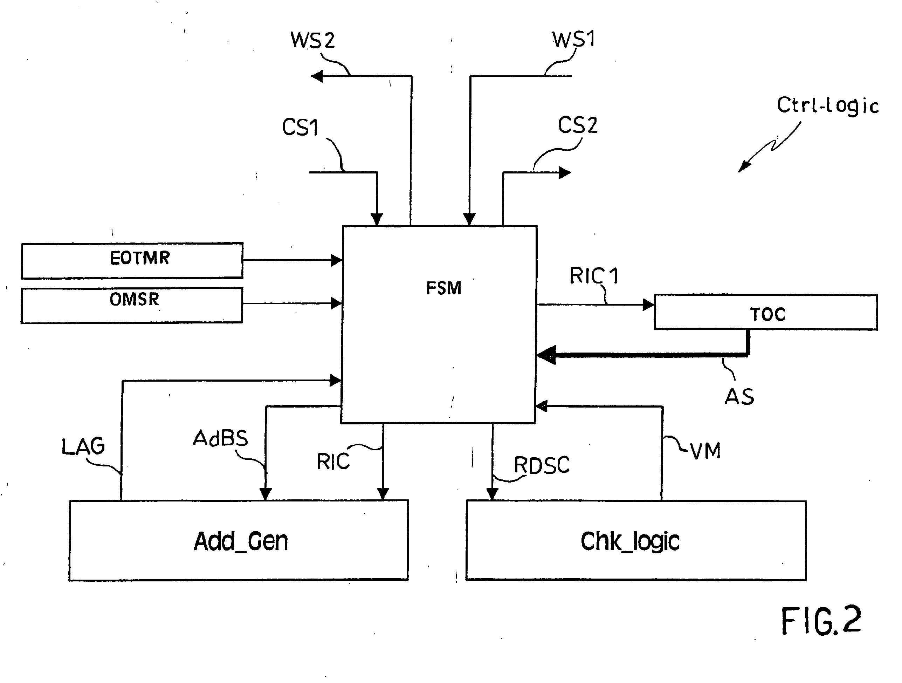

One of the possible implementations of the structure of the control logic Ctrl_logic can be seen, for example, in figure 2.

It is useful to observe that this implementation is compatible with three different modes of accessing the memory Memory by the checker device NVMCC, in accordance with the following invention. Such access modes will be described in detail below.

As mentioned previously, the control logic Ctrl_logic comprises a digital finite state machine FSM that can be made using conventional techniques.

The finite state machine FSM is internally structured by connecting a number of digital logic ports, such as NAND, NOR or FLIP-FLOP ports to one another by circuits.

The finite state machine FSM operates by exchanging a series of digital signals with the microprocessor CPU and with the memory Memory. In particular, the state machine FSM is able to acquire a first control signal CS1 sent by the microprocessor CPU on to the bus Ctrl_signals (see figure 1) with which the same microprocessor CPU requests reading access to the memory Memory. This first signal CS1 is transformed into a second control signal CS2 by the machine FSM to be sent on to the bus Ctrl_signals when the same machine FSM requests reading access to the memory Memory.

Similarly, the state machine FSM is able to acquire a first inhibition or wait signal WS1 sent by the memory Memory on to the bus Ctrl_signals in order to interrupt or inhibit, even temporarily, the access microprocessor CPU. In actual fact, in certain implementations, the memory Memory could provide data to the microprocessor CPU more slowly than the latter supplies the corresponding addresses to the memory Memory. This first wait signal WS1 is transformed into a second inhibition or wait signal WS2 by the machine FSM in order to be sent on to the bus Ctrl-signals when the same machine FSM wants to inhibit or interrupt the access of the microprocessor CPU to the memory Memory.

Moreover, the finite state machine FSM is such as to receive from the address generator Add_Gen a signal corresponding to a last address generated LAG, and send to the address generator Add_Gen an address bus selection signal AdBS and first reload and increment commands RIC. In greater detail, the machine FSM operates by commanding the commutation of the multiplexer MUX through the selection signal AdBS and by reloading and incrementing the counter of the address generator Add_Gen by the first commands RIC.

Similarly, the state machine FSM is such as to send reset and data sampling commands RDSC to the signature register of the check logic Chk_logic, receiving from the latter a value matched VM as a result of the comparison between the data read by the memory Memory and a suitable check value. This check value is stored in a suitable register inside the check logic Chk_logic.

In addition to the state machine FSM, the control logic Ctrl_logic comprises a time out counter TOC, an end of test mode register EOTMR and an operating mode selection register OMSR.

The time out counter TOC performs the function of counting the clock pulses following the reception of second reload and increment commands RIC1 originating from the finite state machine FSM. This counting operation continues until a preset time out value is reached that is suitably signalled to the machine FSM by a warning signal AS. Such time out value, contained in a suitable time out register (not visible in figure 2) corresponds to the duration of a preset time out interval. Moreover, the time out value stored in the abovementioned register is set the first time from outside the chip and, subsequently, can be modified by the microprocessor CPU according to the need for the control operation.

The register EOTMR is such to contain data indicating the type of operations that the finite state machine FSM must perform at the end of a check phase of the content of the memory Memory depending on the result of the check. For this reason, the register EOTMR is connected to the finite state machine FSM in order to transmit to it signals indicating the operations that it must perform.

Finally, the operative mode selection register OMSR is, for example, a programmable 3-bit register that operates to inform the state machine FSM of the mode to use in order to access the same memory Memory. In actual fact, each bit of the register OMSR corresponds to one of the three access modes mentioned previously. Conventionally, in order to select one of the three modes, the bit corresponding to it in the selection register OMSR is fixed, for example, to a logic value 1.

According to a preferred embodiment, the checker device NVMCC object of the invention can access the memory Memory by three different modes.

A first access mode is the shadow mode. On the basis of this first mode the checker device NVMCC accesses the memory Memory only when no other logic circuit (microprocessor CPU or other) accesses it, in other words, in correspondence with free access time slots.

In order to describe how access the memory Memory by the checker device NVMCC takes place in shadow mode, one can refer, for example, to an initial phase in which the microprocessor CPU is accessing the memory Memory having requested to read its data by enabling the first control signal CS1 sent on the bus Ctrl_Signals. In particular, the microprocessor CPU accesses this data by supplying the memory Memory also with the memory location addresses in which they are stored. These addresses arrive at the memory Memory through the second address bus Add_bus2, the multiplexer MUX and the further address bus OUT. The state machine FSM of the control logic Ctrl_logic receiving also a first control signal CS1 is informed of the fact that the microprocessor CPU is accessing the memory Memory.

The control logic Ctrl_logic remains in a standby status during the time slots in which the microprocessor CPU accesses the memory Memory.

When the microprocessor CPU terminates access to the memory Memory, it sees to disabling the first control signal CS1.

The control logic Ctrl_logic reveals the disabling of the first control signal CS1 and can start the checking operation of the content of the locations of memory Memory.

In particular, the state machine FSM requests access to the memory Memory through the second control signal CS2 obtained on the basis of the first signal CS1. The way in which is performed the content check of the memory Memory will be described in greater detail below.

It should be observed that according to the shadow mode described, the content of the memory Memory is checked without delaying the normal performance of operations by the microprocessor CPU.

A second access mode according to the invention is the block mode. In this case, the checker device NVMCC inhibits access to the memory Memory by the microprocessor CPU, and imposes the check on the content of one or all the memory locations.

Conveniently, the block mode is only activated in particular functional phases of the memory system 100. For example, the block mode can be used in the start up phase of the memory system 100, in other words after the RESET phase.

In this case, after RESET, the state machine FSM of the control logic Ctrl_logic prevents access to the memory Memory by the microprocessor CPU by enabling the second wait signal WS2, sent on the bus Ctrl_signals. Subsequently, the logic Ctrl_logic controls a first portion of the memory Memory that generally contains the data relative to the start up of an operating system or even the information on the mode that the device NVMCC must use to control the remaining memory locations.

At the end of the abovementioned control, if the content of the first portion of the memory Memory examined is that expected, the state machine FSM disables the second wait signal WS2, thus simultaneously enabling the microprocessor CPU to read and perform the instructions contained in said first portion.

The block mode guarantees that the microprocessor CPU accesses the stored data only after they have been suitably checked.

Finally the third access mode is mix mode. According to this third mode, access to the memory Memory usually takes place in shadow mode, however an interruption of microprocessor CPU operations is foreseen every time a preset standby interval or time out is exceeded.

In greater detail, after the preset time out interval the checker device NVMCC has not succeeded in accessing the memory Memory in order to check its content, the control logic Ctrl_logic interrupts the access of the microprocessor CPU to the memory Memory by enabling the second wait signal WS2.

In particular, the time out interval value is stored in the control logic Ctrl_logic and the time out counter TOC, by counting the clock pulses, enables the warning signal AS and sends it to the state machine FSM that sees to enabling the second wait signal WS2.

The number of clock pulses that constitutes the time out interval originates from the compromise between the need not to interrupt microprocessor CPU function frequently (as occurs for example by presetting few clock pulses between two subsequent time outs) and the unsuitability of not checking the content of the memory Memory for a long time (e.g. as occurs if many clock pulses elapse between two subsequent interruptions).

According to a variant of the mix mode, instead of the interruption of normal operations of the microprocessor CPU it is foreseen that the same microprocessor CPU and the checker device NVMCC can access the memory Memory in a round robin way. In particular, every time the microprocessor CPU and the control logic Ctrl_logic simultaneously and competitively request access to the memory Memory, the same control logic Ctrl_logic establishes which has access priority, alternating access from one and the other.

According to user requirements, the device NVMCC can be implemented in such a way as to be able to perform access according to one of the abovementioned modes alone, or to provide a checker device NVMCC able to operate according to two or three of the abovementioned access modes.

An example of operation of the memory system 100 is described below. The abovementioned example highlights the sequence of operations that the checker device NVMCC performs in order to check the correctness of the data contained in the memory Memory. Moreover, the operation of the system 100 is analysed starting from the phase subsequent to start up, in other words, after RESET.

In the following example, the system 100 is configured in such a way that, after RESET, the control logic Ctrl_logic accesses the first portion of the memory Memory in block mode. With this arrangement one prevents the microprocessor CPU accessing this first portion without it having been suitably checked. In actual fact, during the design phase, from outside the chip the start address Start_Add and the stop address Stop_Add are fixed corresponding to the first portion of the memory Memory to be controlled, as well as the step value Add_Step used to read the corresponding locations. Moreover, a logic value 1 is fixed from outside in the operative mode selection register OMSR in correspondence with the bit associated to the block mode.

In this way, after the RESET of the system 100, the finite state machine FSM enables the second wait signal WS2 sent to the microprocessor CPU by the signal bus Ctrl_Signals so that the latter does not access the memory Memory. Subsequently, the state machine FSM, having checked that the start address Start_Add does not coincide with the stop address Stop_Add sends the start address Start_Add to the memory Memory through the first address bus Add_bus1, the multiplexer MUX and the further address bus OUT.

The data read in the memory Memory in correspondence with this start address Start_Add is sent, through the data bus Read_Data_bus to the check logic Chk_logic in order to be memorised in the signature register.

In order to reiterate this procedure, the state machine FSM sends the first commands RIC to the counter of the address generator Add_Gen that increments the start address Start_Add of the step value Add_Step, thus providing a second address of the memory Memory. As previously, the datum corresponding to this second address is supplied to the check logic Chk_logic through the data bus Read_Data_Bus. One proceeds in this way until the memory location of Memory corresponding to the stop address Stop_Add is read.

At this point, the check logic Chk_logic compares the data read with the check value stored therein. This comparison takes place, for example, by an error detection code, for example a checksum code or, preferably, the CRC code.

In particular, the checksum code foresees a counter internal to the check logic Chk_logic to sum the data read in the memory Memory and stored in the signature register. Subsequently, the result of the sum is compared with the check value. The checksum code makes it possible to detect one or more errors, but in comparison with other detection methods, it has the drawback that some errors compensate with one another more easily, and are not therefore detected. On the other hand, in the CRC code a suitable check polynomial is implemented within the signature register of the check logic Chk_logic to detect the errors in the data read. In this case, this signature register is far more complex than a traditional register. According to the complexity of the polynomial chosen it is possible to detect one or more errors.

The same data read by the check logic Chk_logic also arrives at the microprocessor CPU (see figure 1) that, being in wait state, does not take them into consideration.

Finite state machine FSM access to the memory Memory concludes when the datum corresponding to the stop address Stop_Add has been read and checked.

If in the first portion of the memory Memory read, errors have been found, the control logic Ctrl_logic can decide to restore the memory system 100 (system reset) especially if the error detected concerns procedures or routines that are fundamental for the subsequent correct function of the same system 100. Simultaneously, the control logic Ctrl_logic enables an input/output pin of the chip on which the system 100 is integrated, in other words, a preset logic signal is applied to this pin. In this way, it is communicated to an external watchdog chip that the checker device NVMCC has found an error.

Instead of the external watchdog chip there can be a logic circuit that removes the supply voltage to the chip of the system 100 in the case in which the checker device NVMCC detects the presence of an error.

On the contrary, if in the first portion of the memory Memory examined no errors are found, the machine FSM informs the microprocessor CPU of this result by ceasing sending the second wait signal WS2 and by commutating, simultaneously, the multiplexer MUX on the second address bus Add_bus2 through the selection signal AdBS.

At this point, the microprocessor CPU, having acquired the control of the system 100, accesses the memory Memory, starting from the locations that have just been controlled, by enabling the first control signal CS1 sent to the memory Memory on the bus Ctrl_signals and sends its own addresses on the second address bus Add_bus2. Simultaneously, the same microprocessor CPU modifies the start address Start-Add, the stop address Stop_Add and the step value Add_Step in the registers of the address generator Add-Gen in order to establish which portion of the memory Memory must be controlled in a subsequent access of the device NVMCC (all the remaining memory or only a part). Moreover, the microprocessor CPU fixes a logic value 1 in the selection register OMSR in correspondence with the new mode of access to the memory Memory, for example the mix mode. Optionally, the microprocessor CPU also fixes a check value inside the check logic Chk_logic.

Whilst the microprocessor CPU accesses the memory Memory, the control logic Ctrl_logic prepares to start a new control procedure by acting on the address generator Add-Gen that provides the new start address Start_Add on the first addresses line Add_bus1.

In any case, being in mix mode the control logic Ctrl_logic cannot access the memory Memory except when the microprocessor CPU is not accessing the memory Memory. Therefore, the new initial start address Start_Add cannot reach the memory Memory until the multiplexer MUX allows the passage only of the addresses present on the second address bus Add-bus2. In correspondence with intervals of time in which the microprocessor CPU does not access the memory Memory (first control signal CS1 disabled), the control logic Ctrl_logic enables the second control signal CS2 in order to access the memory Memory, contemporarily commutating the multiplexer MUX (always with the signal AdBS) between the second Add_bus2 and the first Add_bus1 address bus. In this way, the start address Start_Add is supplied to the memory Memory and the datum corresponding to it is stored in the signature register of the check logic Chk_logic through the data bus Read_Data_bus. At this point, the check process for the presence of errors is the same as that described previously.

If, on the contrary, the microprocessor CPU continuously accesses the memory Memory, the time out counter TOC informs with the warning signal AS the finite state machine FSM of the reaching of the preset time out value, in other words, of the maximum interval of time elapsed since the last control operation. As a consequence, the machine FSM suspends the operation of the microprocessor CPU by enabling the second wait signal WS2 and sends the start address Start_Add to the memory Memory in order to start the checking procedure. Simultaneously, the state machine FSM resets the time out counter TOC with the second commands RIC1.

The microprocessor CPU in wait mode cannot access the memory Memory, but can, however, receive and process data from the other peripheral devices Peripherals.

Once the check operation of the portion of the memory Memory in question has been terminated, if no errors have been found, the control logic Ctrl_logic sends to the microprocessor CPU a first interruption signal indicating both the conclusion of the check operation and the absence of detected errors. As a consequence, the microprocessor CPU continues the check of the system 100 and, in the same way as the case described previously, resets the start address Start_Add and stop address Stop_Add for the subsequent portion of the memory to be controlled. It is possible to repeat the control on other portions of the memory Memory until completing the check of all the data it contains.

If, on the contrary, errors are detected in the portion of the memory Memory in question, the control logic Ctrl_logic sends a second interruption signal to the microprocessor CPU so that it can decide what to do. At this point, the microprocessor CPU can either decide to interrupt its own operations, if it considers the error detected as particularly serious, or it can signal the presence of errors in the procedures relative to the portion of memory controlled so that the latter are not taken into consideration in the future.

Taking as an example the system for managing motor vehicle functions, if an error is detected in the procedures that govern the movement of an electric window, it is sufficient to flag said procedure at non-performable simultaneously notifying the user of the error present. In this way one avoids that in the future the microprocessor CPU performs erroneous instructions compromising the function of the entire system.

According to a particular embodiment of the invention, during the function of the system 100, once the entire memory Memory has been controlled at least once (after RESET) with the modes described previously (block and mix), the microprocessor CPU fixes a logic value 1 in the operative mode selection register OMSR in correspondence with the bit relative to the shadow mode. With this arrangement, the checker device NVMCC will cyclically perform the control of the locations of the memory Memory without delaying the performance of the operations of the microprocessor CPU.

Alternatively, it is possible to enable the mix mode and, therefore, to cyclically perform the check of the memory Memory locations ensuring that the memory itself is entirely rechecked within a preset interval of time. For example, it is possible to establish that the entire memory Memory is rechecked within an interval of time not greater than a number N of time out intervals.

This arrangement guarantees to the user that all the memory Memory content is periodically checked (for example, every ten minutes).

One important advantage of the invention concerns the possibility of performing the check of the locations of the memory Memory by the checker device NVMCC that is distinct from the microprocessor CPU, in other words its control logic Ctrl-Logic is distinct from the microprocessor CPU. In this way, the microprocessor CPU is not assigned check operations on the correctness of the data stored, and therefore its performance is not required to be particularly high. In actual fact, in the example described, the microprocessor CPU only intervenes to modify the start address, the stop address, the step value and the bit corresponding to the mode of access to the memory Memory by the checker device NVMCC.

Moreover, the control logic Ctrl_logic of the device NVMCC can have a simpler structure than a microprocessor as it performs a lower number of operations than the latter. As a consequence, the control logic Ctrl_logic is also advantageously less costly than a microprocessor.

Moreover, in shadow mode, the device NVMCC performs, advantageously, the check of the data in the memory Memory without restricting the operation of the microprocessor CPU, but working in a non-conflicting way with it.

In alternative, the mix mode described above is particularly advantageous because it makes it possible to perform the check of the memory Memory in a cyclical manner in a preset interval of time interrupting the accesses of microprocessor CPU with the time out.

The system described also consents considerable flexibility in the choice of the portions of memory to be checked, in other words in the determination of the dimensions of the memory object of the check and in the evaluation of the corresponding addresses.

Obviously, a man skilled in the art can make further modifications and variants to the memory system of the present invention, with the purpose of satisfying contingent and specific requirements.

For example, according to a possible variant, the checker device NVMCC is a coprocessor or dedicated logic, external to the memory Memory or integrated into it, that is capable of automatically checking the content of the memory Memory reducing or completely eliminating the interferences with the operations performed by the microprocessor CPU.

Moreover, the memory Memory of the system 100 may comprise volatile type cells such as RAM in alternative to non-volatile ones.

Finally, instead of the memory system object of the invention integrated in a single chip, an alternative solution could foresee the making of distinct chips for the memory Memory, the microprocessor CPU and for the checker device NVMCC.

The abovementioned variants and modification are all contained within the scope of the invention, as defined by the following claims.

## Claims

1. Memory system (100) including:
- a memory matrix (Memory) for storing digital data;
- processing and controlling means (CPU) for interacting with the memory matrix for reading said digital data and performing corresponding operations,
**characterized in that** the system comprises an error detection device (NVMCC) distinct from said processing and controlling means (CPU) suitable for accessing the memory matrix in order to perform an at least partial reading of the memory matrix and detecting the presence of alterations of the digital stored data, the error detection device allowing to inhibit the performance of the operations by the processing and controlling means (CPU) or to send to the processing and controlling means (CPU) a signal indicating the error detection.

2. The memory system (100) according to claim 1, wherein the error detection device (NVMCC) is connected to the processing and controlling means (CPU) to receive a first signal (CS1) indicating the operative state of said processing means, the detection device (NVMCC), on the basis of said first signal, being it such to access the memory matrix (Memory) when said means do not interact with the memory matrix.

3. The memory system (100) according to claim 2, wherein, according to a first operative mode, the detection device (NVMCC), on the basis of said first signal (CS1), is such to remain in a wait state in which it does not access the memory matrix (Memory) when said processing means (CPU) interact with the memory matrix.

4. The memory system (100) according to claim 1, wherein, in accordance with a second operative mode, the error detection device (NVMCC) is connected to the processing and controlling means (CPU) for sending to said processing means a signal inhibiting (WS2) the access to the memory matrix (Memory), the detection device, being able to access the memory matrix after the inhibition of access by the processing means.

5. The memory system according to claims 2 and 4, wherein, in accordance with a third operative mode, the detection device (NVMCC) is such to remain in said wait state for a time not greater than a wait interval of a preset value, at the end of said interval, the detection device being such as to send said signal of inhibition (WS2) to the processing means (CPU).

6. The memory system (100) according to claim 1, wherein the error detection device (NVMCC) comprises:
- a control logic (Ctrl_logic), distinct from said processing and controlling means (CPU), for managing accesses to the memory matrix (Memory) and checking the correctness of the data it contains,
- an address generator (Add_Gen) controlled by the control logic for generating the addresses of the memory matrix locations to be read and supplying them to the memory matrix,
- a check logic (Chk_logic) controlled by the control logic for evaluating the correctness of the data contained in said memory locations by an error detection code.

7. The memory system (100) according to at least one of the previous claims, wherein the control logic (Ctrl_logic) comprises a digital finite state machine (FSM) for exchanging digital signals (CS1,CS2,WS1,WS2) with the processing and controlling means (CPU) and with the memory matrix (Memory).

8. The memory system (100) according to claims 5 and 6, wherein the control logic (Ctrl_logic) also comprises a time out counter (TOC) for counting clock pulses and such as to send a warning signal (AS) of reaching wait interval duration.

9. The memory system (100) according to at least one of the previous claims, in which said control logic (Ctrl_logic) also comprises:
- an end of test mode register (EOTMR) for transmitting to the state machine (FSM) instructions corresponding to operations to be performed at the end of said memory matrix (Memory) reading for the detection of alterations, and
- a selection register for containing a datum representative of said first, second and third operative mode (OMSR) in order to inform the finite state machine (FSM) of the mode to use to access the same memory matrix.

10. The memory system (100) according to claim 6, wherein the address generator (Add_Gen) comprises a counter and three registers (Start_Add, Stop_Add, Add_step) for memorising a start address, a stop address and a step value, respectively, said addresses identifying at least one portion of the memory matrix (Memory).

11. The memory system (100) according to at least one of the previous claims, wherein the memory matrix (Memory), the processing and controlling means (CPU) and the error detection device (NVMCC) are integrated in a single chip of semiconductor material or, in alternative, each of them is integrated on a separate chip.

12. Method of managing a memory system comprising a memory matrix (Memory) containing digital data and processing and controlling means (CPU) destined to interact with the memory matrix in order to read the digital data and perform the corresponding operations, the method being **characterised by** the fact of comprising the phases of:
performing an at least partial reading of the memory matrix in order to detect the presence of alterations to the digital data stored, said reading being performed by an error detection device distinct from said processing and controlling means (CPU),
generating an inhibition signal in order to inhibit the performance of operations by the processing and controlling means (CPU) or sending to the processing and controlling means (CPU) a signal indicating the error detected, the phases of generating the inhibition signal and sending of the signal indicating the detection of the error being performed by said detection device.

13. The method according to claim 12, wherein said detection reading comprises a phase of receiving, by the error detection device (NVMCC), a first signal (CS1) indicating the operative state of said processing and controlling means (CPU).

14. The method according to claim 13, also comprising the phases of:
performing access to the memory matrix by the detection device (NVMCC), when said first signal (CS1) indicates that the processing and controlling means do not interact with the memory matrix,
maintaining the detection device in a wait state in which it does not access the memory matrix (Memory), when said first signal (CS1) indicates that said processing means interact with the memory matrix.

15. The method according to claim 12, wherein said detection reading also comprises the phase of sending by the error detection device (NVMCC) an interruption signal (WS2) of access to the memory matrix (Memory) to the processing and controlling means (CPU), the detection device being able to access the memory matrix after the interruption of access by said processing means.

16. The method according to claims 14 and 15, comprising a phase of sending said interruption signal (WS2) to the processing means (CPU), by the detection device (NVMCC) when said wait state is greater than a preset waiting time interval.

17. The method according to claim 12, comprising, subsequent to said detection reading, a phase of sending to said processing and controlling means (CPU) by the error detection device (NVMCC) a signal indicating the absence of errors detected.

## Patentansprüche

1. Speichersystem (100), das enthält:
eine Speichermatrix (Speicher) zum Speichern digitaler Daten;
eine Verarbeitungs-und-Steuer-Einrichtung (CPU), die in Wechselwirkung mit der Speichermatrix tritt, um die digitalen Daten zu lesen und entsprechende Operationen durchzuführen,
**dadurch gekennzeichnet, dass** das System eine Fehlererfassungsvorrichfung (NVMCC) getrennt von der Verarbeitungs-und-Steuer-Einrichtung (CPU) umfasst, die sich dazu eignet, auf die Speichermatrix zuzugreifen, um wenigstens ein teilweises Lesen der Speichermatrix und Erfassen des Vorhandenseins von Änderungen der gespeicherten digitale Daten durchzuführen, wobei es die Fehlererfassungsvorrichtung ermöglicht, die Durchführung der Operationen durch die Verarbeitungs-und-Steuer-Einrichtung (CPU) zu verhindern oder ein Signal zu der Verarbeitungs-und-Steuer-Einrichtung (CPU) zu senden, das die Fehlererfassung anzeigt.

2. Speichersystem (100) nach Anspruch 1, wobei die Fehlererfassungsvorrichtung (NVMCC) mit der Verarbeitungs-und-Steuer-Einrichtung (CPU) verbunden ist, um ein erstes Signal (CS1) zu empfangen, das den Betriebszustand der Verarbeitungseinrichtung anzeigt, und die Erfassungsvorrichtung (NVMCC) auf Basis des ersten Signals auf die Speichermatrix (Speicher) zugreift, wenn die Einrichtung nicht in Wechselwirkung mit der Speichermatrix tritt.

3. Speichersystem (100) nach Anspruch 2, wobei entsprechend einem ersten Betriebsmodus die Erfassungsvorrichtung (NVMCC) auf Basis des ersten Signals (CS1) in einem Wartezustand verbleibt, in dem sie nicht auf die Speichermatrix (Speicher) zugreift, wenn die Verarbeitungseinrichtung (CPU) in Wechselwirkung mit der Speichermatrix tritt.

4. Speichersystem (100) nach Anspruch 1, wobei entsprechend einem zweiten Betriebsmodus die Fehlererfassungsvorrichtung (NVMCC) mit der Verarbeitungs-und-Steuer-Einrichtung (CPU) verbunden ist, um ein Signal (WS2) zu der Verarbeitungseinrichtung zu senden, das den Zugriff auf die Speichermatrix (Speicher) verhindert, und die Erfassungsvorrichtung in der Lage ist, nach der Verhinderung des Zugriffs durch die Verarbeitungseinrichtung auf die Speichermatrix zuzugreifen.

5. Speichersystem nach den Ansprüchen 2 und 4, wobei entsprechend einem dritten Betriebsmodus die Erfassungsvorrichtung (NVMCC) über eine Zeit in dem Wartezustand verbleibt, die nicht länger ist als ein Warte-Intervall eines voreingestellten Wertes, und die Erfassungsvorrichtung am Ende des Intervalls das Signal zur Verhinderung (WS2) zu der Verarbeitungseinrichtung (CPU) sendet.

6. Speichersystem (100) nach Anspruch 1, wobei die Fehlererfassungsvorrichtung (NVMCC) umfasst:
eine Steuerlogik (Ctrl_Iogic) getrennt von der Verarbeitungs-und-Steuer-Einrichtung (CPU), die Zugriffe auf die Speichermatrix (Speicher) verwaltet und die Richtigkeit der Daten prüft, die sie enthält,
einen Adressgenerator (Add_Gen), der durch die Steuerlogik gesteuert wird, um die Adressen der zu lesenden Speichermatrixorte zu erzeugen und sie der Speichermatrix zuzuführen,
eine Prüflogik (Chk_logic), die durch die Steuerlogik gesteuert wird, um die Richtigkeit der an Speicherorten enthaltenen Daten mittels eines Fehlererfassungscodes zu bewerten.

7. Speichersystem (100) nach wenigstens einem der vorangehenden Ansprüche, wobei die Steuerlogik (Ctrl_logic) einen digitalen endlichen Automaten (FSM) zum Austauschen digitaler Signale (CS1, CS2, WS1, WS2) mit der Verarbeitungs-und-Steuer-Einrichtung (CPU) und mit der Speichermatrix (Speicher) umfasst.

8. Speichersystem (100) nach den Ansprüchen 5 und 6, wobei die Steuerlogik (Ctrl_logic) des Weiteren einen Zeitüberwachungszähler (TOC) zum Zählen von Taktimpulsen umfasst, der beim Erreichen einer Warteintervalldauer ein Warnsignal (AS) sendet.

9. Speichersystem (100) nach wenigstens einem der vorangehenden Ansprüche, wobei die Steuerlogik (Ctrl_logic) des Weiteren umfasst:
ein Testmodusabschluss-Register (EOTMR) zum Übertragen von Befehlen zu dem endlichen Automaten (FSM), die Operationen entsprechen, die zum Abschluss des Lesens der Speichermatrix (Speicher) zur Erfassung von Änderungen durchzuführen sind, und
ein Auswahlregister, das ein Datenelement enthält, das repräsentativ für den ersten, den zweiten und den dritten Betriebsmodus (OMSR) ist, um den endlichen Automaten (FSM) über den Modus zu informieren, der zum Zugreifen auf die Speichermatrix zu verwenden ist.

10. Speichersystem (100) nach Anspruch 1, wobei der Adressgenerator (Add_Gen) einen Zähler und drei Register (Start_Add, Stop_Add, Add_stepp) zum Speichern einer Startadresse, einer Stoppadresse bzw. eines Schrittwertes umfasst, und die Adressen wenigstens einen Abschnitt der Speichermatrix (Speicher) identifizieren.

11. Speichersystem (100) nach wenigstens einem der vorangehenden Ansprüche, wobei die Speichermatrix (Speicher), die Verarbeitungs-und-Steuer-Einrichtung (CPU) und die Fehlererfassungsvorrichtung (NVMCC) in einen einzelnen Chip aus Halbleitermaterial integriert sind oder, als Alternative dazu, jede von ihnen auf einem separaten Chip integriert ist.

12. Verfahren zum Verwalten eines Speichersystems, das eine Speichermatrix (Speicher), die digitale Daten enthält, sowie eine Verarbeitungs-und-Steuer-Einrichtung (CPU) umfasst, die dazu bestimmt ist, mit der Speichermatrix in Wechselwirkung zu treten, um die digitalen Daten zu lesen und die entsprechenden Operationen durchzuführen, wobei das Verfahren durch die Tatsache **gekennzeichnet** ist, dass es die folgenden Phasen umfasst:
Durchführen eines wenigstens teilweisen Lesens der Speichermatrix, um das Vorhandensein von Änderungen an den gespeicherten digitalen Daten zu erfassen, wobei das Lesen durch eine Fehlererfassungsvorrichtung separat von der Verarbeitungs-und-Steuer-Einrichtung (CPU) durchgeführt wird,
Erzeugen eines Verhinderungssignals, um die Durchführung von Operationen durch die Verarbeitungs-und-Steuer-Einrichtung (CPU) zu verhindern, oder Senden eines Signals zu der Verarbeitungs-und-Steuer-Einrichtung (CPU), das den erfassten Fehler anzeigt, wobei die Phasen des Erzeugens des Verhinderungssignals und des Sendens des Signals, das die Erfassung des Fehlers anzeigt, durch die Erfassungsvorrichtung durchgeführt werden.

13. Verfahren nach Anspruch 12, wobei das Erfassungslesen eine Phase des Empfangens eines ersten Signals (CS1) durch die Fehlererfassungsvorrichtung (NVMCC) umfasst, das den Betriebszustand der Verarbeitungs-und-Steuer-Einrichtung (CPU) anzeigt.

14. Verfahren nach Anspruch 13, das des Weiteren die folgenden Phasen umfasst:
Durchführen von Zugriff auf die Speichermatrix durch die Erfassungsvorrichtung (NVMCC), wenn das erste Signal (CS1) anzeigt, dass die Verarbeitungs-und-Steuer-Einrichtung nicht in Wechselwirkung mit der Speichermatrix tritt,
Halten der Erfassungsvorrichtung in einem Wartezustand, in dem sie nicht auf die Speichermatrix (Speicher) zugreift, wenn das erste Signal (CS1) anzeigt, dass die Verarbeitungseinrichtung in Wechselwirkung mit der Speichermatrix tritt.

15. Verfahren nach Anspruch 12, wobei das Erfassungslesen des Weiteren die Phase des Sendens eines Signals (WS2) zur Unterbrechung von Zugriff auf die Speichermatrix (Speicher) durch die Fehlererfassungsvorrichtung (NVMCC) zu der Verarbeitungs-und-Steuer-Einrichtung (CPU) umfasst und die Erfassungsvorrichtung in der Lage ist, nach der Unterbrechung von Zugriff durch die Verarbeitungseinrichtung auf die Speichermatrix zuzugreifen.

16. Verfahren nach den Ansprüchen 14 und 15, das eine Phase des Sendens des Unterbrechungssignals (WS2) zu der Verarbeitungseinrichtung (CPU) durch die Erfassungsvorrichtung (NVMCC) umfasst, wenn der Wartezustand länger ist als ein voreingestelltes Wartezeitintervall.

17. Verfahren nach Anspruch 12, das anschließend an das Erfassungslesen eine Phase des Sendens eines Signals, das das Nichtvorhandensein erfasster Fehler anzeigt, zu der Verarbeitungs-und-Steuer-Einrichtung (CPU) durch die Fehlererfassungsvorrichtung (NVMCC) umfasst.

## Revendications

1. Système de mémoire (100) comportant :
- une matrice mémoire (Memory) pour stocker des données numériques ;
- des moyens de traitement et de commande (CPU) pour interagir avec la matrice mémoire afin de lire lesdites données numériques et exécuter les opérations correspondantes,
**caractérisé en ce que** le système comprend un dispositif de détection d'erreur (NVMCC), distinct desdits moyens de traitement et de commande (CPU), adapté à accéder à la matrice mémoire afin d'effectuer une lecture au moins partielle de la matrice mémoire et détecter la présence d'altérations des données numériques stockées, le dispositif de détection d'erreur permettant d'inhiber l'exécution des opérations par les moyens de traitement et de commande (CPU) ou d'envoyer aux moyens de traitement et de commande (CPU) un signal indiquant la détection d'erreur.

2. Système de mémoire (100) selon la revendication 1, dans lequel le dispositif de détection d'erreur (NVMCC) est relié aux moyens de traitement et de commande (CPU) afin de recevoir un premier signal (CS1) indiquant l'état de fonctionnement desdits moyens de traitement, le dispositif de détection (NVMCC), en se basant sur ledit premier signal, est de nature à accéder à la matrice mémoire (Memory) lorsque lesdits moyens n'interagissent pas avec la matrice mémoire.

3. Système de mémoire (100) selon la revendication 2, dans lequel, dans un premier mode de fonctionnement, le dispositif de détection (NVMCC), en se basant sur le premier signal (CS1), est de nature à demeurer dans un état d'attente dans lequel il n'accède pas à la mémoire matrice (Memory) lorsque lesdits moyens de traitement (CPU) interagissent avec la matrice mémoire.

4. Système de mémoire (100) selon la revendication 1, dans lequel, dans un deuxième mode de fonctionnement, le dispositif de détection d'erreur (NVMCC) est relié aux moyens de traitement et de commande (CPU) afin d'envoyer auxdits moyens de traitement un signal arrêtant (WS2) l'accès à la matrice mémoire (Memory), le dispositif de détection étant capable d'accéder à la matrice mémoire après l'arrêt de l'accès par les moyens de traitement.

5. Système de mémoire selon les revendications 2 et 4, dans lequel, dans un troisième mode de fonctionnement, le dispositif de détection (NVMCC) est de nature à demeurer dans ledit état d'attente pendant une durée inférieure ou égale à l'intervalle d'attente d'une valeur prédéfinie, à l'expiration dudit intervalle, le dispositif de détection étant de nature à envoyer ledit signal d'inhibition (WS2) aux moyens de traitement (CPU).

6. Système de mémoire (100) selon la revendication 1, dans lequel le dispositif de détection d'erreur (NVMCC) comprend :
- une logique de commande (Ctrl_logic), distincte desdits moyens de traitement et de commande (CPU), pour gérer les accès à la matrice mémoire (Memory) et vérifier l'exactitude des données qu'elle contient,
- un générateur d'adresses (Add_Gen) régulé par la logique de commande pour générer les adresses des emplacements de la matrice mémoire devant être lus et les fournir à la matrice mémoire,
- une logique de vérification (Chk_logic) régulée par la logique de commande pour évaluer l'exactitude des données contenues dans lesdits emplacements de mémoire par un code de détection d'erreur.

7. Système de mémoire (100) selon l'une au moins des revendications précédentes, dans lequel la logique de commande (Ctrl_logic) comprend une machine numérique à états finis (FSM) pour échanger des signaux numériques (CS1, CS2, WS1, WS2) avec les moyens de traitement et de commande (CPU) et avec la matrice mémoire (Memory).

8. Système de mémoire (100) selon les revendications 5 et 6, dans lequel la logique de commande (Ctrl_logic) comprend également un compteur de temps imparti (TOC) pour compter des impulsions d'horloge et est de nature à envoyer un signal d'avertissement (AS) indiquant l'atteinte de la durée de l'intervalle d'attente.

9. Système de mémoire (100) selon l'une au moins des revendications précédentes, dans lequel ladite logique de commande (Ctrl_logic) comprend également :
- un registre de mode de fin d'essai (EOTMR) pour transmettre à la machine à états (FSM) des instructions correspondant à des opérations devant être effectuées à la fin de ladite lecture de la matrice mémoire (Memory) en vue de la détection d'altérations, et
- un registre de sélection pour contenir une référence représentative desdits premier, deuxième et troisième modes de fonctionnement (OMSR.) afin de signaler à la machine à états finis (FSM) le mode à utiliser pour accéder à la même matrice mémoire.

10. Système de mémoire (100) selon la revendication 6, dans lequel le générateur d'adresses (Add_Gen) comprend un compteur et trois registres (Start_Add, Stop_Add, Add_step) pour mémoriser respectivement une adresse de début, une adresse d'arrêt et une valeur de pas, lesdites adresses identifiant au moins une partie de la matrice mémoire (Memory).

11. Système de mémoire (100) selon l'une au moins des revendications précédentes, dans lequel la matrice mémoire (Memory), les moyens de traitement et de commande (CPU) et le dispositif de détection d'erreur (NVMCC) sont intégrés dans une seule puce du matériau semiconducteur ou bien, en variante, chacun d'eux est intégré sur une puce séparée.

12. Procédé de gestion d'un système de mémoire comprenant une matrice mémoire (Memory) contenant des données numériques et des moyens de traitement et de commande (CPU) destinés à interagir avec la matrice mémoire afin de lire le données numériques et exécuter les opérations correspondantes, le procédé étant **caractérisé par** le fait de comprendre les phases consistant à :
effectuer une lecture au moins partielle de la matrice mémoire afin de détecter la présence d'altérations des données numériques stockées, ladite lecture étant effectuée par un dispositif de détection d'erreur distinct desdits moyens de traitement et de commande (CPU),
générer un signal d'inhibition afin d'inhiber l'exécution des opérations par les moyens de traitement et de commande (CPU) ou envoyer aux moyens de traitement et de commande (CPU) un signal indiquant l'erreur détectée, les phases consistant à générer un signal et à envoyer le signal indiquant la détection d'erreur étant exécutées par ledit dispositif de détection.

13. Procédé selon la revendication 12, dans lequel ladite lecture de détection comprend une phase consistant à recevoir, par le dispositif de détection d'erreur (NVMCC), un premier signal (CS1) indiquant l'état de fonctionnement desdits moyen de traitement et de commande (CPU).

14. Procédé selon la revendication 13, comprenant également les phases consistant à :
effectuer l'accès à la matrice mémoire par le dispositif de détection (MVMCC), lorsque ledit premier signal (CS1) indique que les moyens de traitement et de commande n'interagissent pas avec la matrice mémoire,
maintenir le dispositif de détection dans un état d'attente dans lequel il n'accède pas à la matrice mémoire (Memory), lorsque ledit premier signal (CS1) indique que lesdits moyens de traitement interagissent avec la matrice mémoire.

15. Procédé selon la revendication 12, dans lequel ladite lecture de détection comprend également la phase consistant à envoyer par le dispositif de détection d'erreur (NVMCC) un signal d'interruption (WS2) de l'accès à la matrice mémoire (Memory) aux moyens de traitement et de commande (CPU), le dispositif de détection étant capable d'accéder à la matrice mémoire après l'interruption de l'accès par lesdits moyens de traitement.

16. Procédé selon les revendications 14 et 15, comprenant une phase consistant à envoyer ledit signal d'interruption (WS2) aux moyens de traitement (CPU), par le dispositif de détection (NVMCC) lorsque ledit état d'attente est supérieur à un intervalle de temps d'attente prédéfini.

17. Procédé selon la revendication 12, comprenant, à la suite de ladite lecture de détection, une phase consistant à envoyer auxdits moyens de commande et de traitement (CPU) par le dispositif de détection d'erreur (NVMCC) un signal indiquant l'absence d'erreur détectée.
